# EUROPÄISCHE PATENTSCHRIFT

(11) **EP 3 257 157 B1**
(45) Veröffentlichungstag und Bekanntmachung des Hinweises auf die Patenterteilung: **06.11.2019**
(21) Anmeldenummer: 16701937.1
(22) Anmeldetag: 28.01.2016
(51) Int. Cl.: H03K 5/08, H01L 27/02, H02H 9/04, H03K 17/12

(54) **SCHALTUNGSANORDNUNG ZUM SCHUTZ EINER AUS EINEM VERSORGUNGSNETZ ZU BETREIBENDEN EINHEIT GEGEN ÜBERSPANNUNGEN**
CIRCUIT ASSEMBLY FOR PROTECTING A UNIT TO BE OPERATED FROM A SUPPLY NETWORK AGAINST OVERVOLTAGE
MONTAGE SERVANT À PROTÉGER CONTRE LES SURTENSIONS UNE UNITÉ FONCTIONNANT À PARTIR D'UN RÉSEAU DE DISTRIBUTION

(30) Priorität: 10.02.2015 DE 102015001680; 08.04.2015 DE 102015004523
(43) Veröffentlichungstag der Anmeldung: 20.12.2017
(73) Patentinhaber: DEHN SE + Co KG, 92318 Neumarkt / Opf. (DE)
(72) Erfinder: SCHORK, Franz, 90461 Nürnberg (DE); BROCKE, Ralph, 98693 Ilmenau / Oberpörlitz (DE); BÖHM, Thomas, 92366 Hohenfels (DE); DONAUER, Dominik, 92331 Parsberg (DE)
(74) Vertreter: Kruspig, Volkmar
(86) Internationale Anmeldenummer: PCT/EP2016/051811
(87) Internationale Veröffentlichungsnummer: WO 2016/128225

(56) Entgegenhaltungen:
- EP-A1- 2 549 649
- EP-A1- 2 757 688
- EP-A2- 2 256 806
- DE-A1- 10 338 921
- DE-A1-102007 049 928
- DE-A1-102009 022 832
- US-A- 3 246 206
- US-A1- 2008 192 394
- US-A1- 2011 058 299
- US-B1- 6 268 990

## Beschreibung

Die Erfindung betrifft eine Schaltungsanordnung zum Schutz einer aus einem Versorgungsnetz zu betreibenden Einheit gegen Überspannungen mit einem Eingang mit erstem und zweitem Eingangsanschluss, die mit dem Versorgungsnetz in Verbindung stehen, und einem Ausgang mit einem ersten und einem zweiten Ausgangsanschluss, an denen die zu schützende Einheit anschließbar ist, sowie mit einer Schutzschaltung, die zwischen erstem und zweitem Eingangsanschluss vorgesehen ist, um die an ihr anliegende Spannung zu begrenzen, gemäß Oberbegriff des Anspruchs 1.

Aus der EP 0 431 215 A1 ist ein Verfahren und eine Anordnung zum Schutz eines abschaltbaren Thyristors vor unzulässiger Überspannung vorbekannt. Gemäß der dortigen Lehre wird die Anodenspannung des abschaltbaren Thyristors in Bezug auf seine Kathodenspannung überwacht und bei Überschreitung eines vorbestimmten Grenzwertes ein Steuersignal generiert, wodurch die am Gate des abschaltbaren Thyristors angeschaltete negative Spannungsquelle abgeschaltet und der abschaltbare Thyristor mittels des Einschaltkreises eingeschaltet wird. Auf diese Weise sind abschaltbare Thyristoren vor unzulässiger Überspannung schützbar.

Die DE 103 38 921 A1 und US 2011/0058299 A1 offenbaren eine Schaltungsanordnung zum Schutz gegen Stoßspannungen. Der dortigen Aufgabenstellung liegt das Problem zugrunde, Geräte gegen Stoßspannungen, die z.B. durch Blitzschlag auf einem Spannungsnetz entstehen, zu schützen.

Die diesbezüglich vorgesehene Schutzschaltung umfasst neben einer Begrenzungsvorrichtung eine Schalteranordnung. Die Schalteranordnung umfasst ein Schaltelement und eine Ansteuerungsschaltung für das Schaltelement, wobei, um eine ausreichend präzise Dimensionierung sicherzustellen, das Schaltelement als Halbleiterbauelement ausgebildet ist.

Die Schaltervorrichtung und die Begrenzungsvorrichtung sind seriell angeordnet und so ausgelegt, dass bei einem vorgebbaren ersten Auslösekriterium die Schaltervorrichtung leitend wird und bei einem vorgegebenen zweiten Auslösekriterium sperrt.

Als Begrenzungsvorrichtung wird ein Varistor und/oder ein ohmscher Widerstand und/oder eine Zenerdiode eingesetzt. Das Schaltelement ist beispielsweise als Triac und/oder Diac oder als Thyristor oder aber IGBT (Insolated Gate Bipolar Transistor) ausgeführt.

Allen Ausführungsformen gemäß DE 103 38 921 A1 oder US 2001/0058299 A1 ist gemeinsam, dass das begrenzende Element als Varistor, Widerstand oder Zenerdiode zu realisieren ist.

Aus dem Vorgenannten ist es daher Aufgabe der Erfindung, eine weiterentwickelte Schaltungsanordnung zum Schutz einer aus einem Versorgungsnetz zu betreibenden Einheit gegen Überspannungen anzugeben, welche über ein sehr schnelles, sicheres und reproduzierbares Ansprechverhalten verfügt und die in einfacher Weise mit überschaubaren Kosten realisierbar sowie in elektronischen Baugruppen integrierbar ist.

Die Lösung der Aufgabe der Erfindung erfolgt durch eine Schaltungsanordnung gemäß der Merkmalskombination nach Patentanspruch 1, wobei die Unteransprüche mindestens zweckmäßige Ausgestaltungen und Weiterbildungen darstellen.

Bei der erfindungsgemäßen Lösung wird von dem Grundgedanken ausgegangen, einen Leistungshalbleiter als überspannungsbegrenzendes Element unmittelbar einzusetzen und hierbei den Leistungshalbleiter im Clampingmodus zu betreiben. Erfindungsgemäß wird der eingesetzte Leistungshalbleiter über eine Reihenschaltung aus z.B. einem Diac oder einer Thyristordiode und einer TVS bzw. Zenerdiode angesteuert.

Der Halbleiter selbst ist dabei im Querzweig vorgesehen, wobei die Ansteuerschaltung bezogen auf den Leistungshalbleiter lediglich der Überspannungserkennung und der Aktivierung des Halbleiters dient. Der eingesetzte Leistungshalbleiter wird damit sowohl als schaltendes als auch als eigentlich begrenzendes Element genutzt und realisiert in diesem Sinne eine Doppelfunktion.

Bei einer bevorzugten Ausgestaltung der Erfindung wird die Schutzschaltung über eine mit dem Eingang in Verbindung stehende Diodenbrücke gespeist, so dass negative, aber auch positive Überspannungsimpulse bzw. entsprechende Stoßströme erkenn- und ableitbar sind.

Bei einer weiteren Ausführungsform ist dem Leistungshalbleiter zum Zweck der Stromaufteilung ein Thyristor parallel geschalten.

Zwischen der Kathode des Thyristors und dem Emitter des Leistungshalbleiters kann noch ein Löschkondensator vorgesehen sein.

Zum Zweck der Spannungsbegrenzung wird demnach der Leistungshalbleiter passiv gesteuert und ausschließlich im Clampingmodus betrieben. Das Clampingelement besteht aus einer Reihenschaltung von einem Diac und einem Zenerelement, wobei die Summe der Zener- und der Diac-Spannung die Clampingspannung ergibt. Diese wird knapp über die maximale netzfrequente Spannung, die einige Sekunden anliegen kann, d.h. die sogenannte TOV-Spannung, gelegt. Somit wird der Schutzpegel auf seinen minimal möglichen Wert einstellbar. Die ansonsten übliche Auslegung von 90% unterhalb der maximalen Spannung des Leistungshalbleiters muss nicht eingehalten werden.

Im Fall eines Auftretens einer Überspannung ergibt sich eine Clampingspannung von U_{clamp} = U_{G} + U_{diac} + U_{zener}.

Nach Überschreiten der Durchbruchspannung, z.B. nach ca. 1 µs wird der Diac leitend und es bricht die Clampingspannung zusammen. Damit ergibt sich U_{clamp} = U_{G} + U_{zener}.

Wenn die Zenerspannung genau auf die Netzspannung gelegt wird, ergibt sich ein deutlich reduzierter Energieumsatz während des Ableitvorgangs im Leistungshalbleiter.

Mit der erwähnten Parallelschaltung des Thyristors ist eine weitere Erhöhung der Stoßstromtragfähigkeit möglich.

In diesem Fall übernimmt der Leistungshalbleiter, insbesondere ein IGBT den Stoßstrom im Clampingmodus, bis der Thyristor zündet.

Danach übernimmt der Thyristor wegen seiner niedrigeren Durchlassspannung den vollen Stoßstrom.

Der erwähnte, mit dem Thyristor in Reihe geschaltete Kondensator lädt sich bis auf die Netzspannung auf. Hierdurch wird der Haltestrom des Thyristors unterschritten und dieser sperrt.

Weiterhin kann ausgestaltend der Kondensator zur Impulsauswertung genutzt werden. Je nachdem, wie weit dieser nach dem Überspannungsimpuls eine Ladung aufweist, kann ein Rückschluss auf die Energiemenge des Impulses gezogen werden.

Die Erfindung geht also von einer Schaltungsanordnung zum Schutz einer aus einem Versorgungsnetz zu betreibenden Einheit gegen Überspannungen mit einem Eingang mit erstem und zweitem Eingangsanschluss aus, die mit dem Versorgungsnetz in Verbindung stehen. Weiterhin weist die Schaltungsanordnung einen Ausgang mit einem ersten und einem zweiten Ausgangsanschluss auf, an denen die zu schützende Einheit anschließbar ist. Weiterhin ist eine Schutzschaltung vorgesehen, die zwischen erstem und zweitem Eingangsanschluss befindlich ist, um die an ihr anliegende Spannung zu begrenzen.

Erfindungsgemäß weist die Schutzschaltung einen Leistungshalbleiter, insbesondere einen IGBT auf, wobei zwischen Kollektor und Gate des Leistungshalbleiters eine Reihenschaltung aus einem Diac, d.h. einer Zweirichtungsdiode, und einem Zenerelement angeschlossen ist, wobei die Summe der Zener- und der Diac-Spannung eine Clampingspannung für den Leistungshalbleiter ergibt, welche oberhalb der Spannung des Versorgungsnetzes liegt und den Schutzpegel definiert.

In einer bevorzugten Ausführungsform der Erfindung wird die Schutzschaltung über eine Diodenbrücke gespeist. Hierdurch kann ein Leistungshalbleiter-Bauelement eingespart werden, indem die relevante Überspannung bzw. ein auftretender Stoßstrom gleichgerichtet wird und zur Ansteuerung des (einzigen) Leistungshalbleiters Anwendung findet.

Bei der Ausführungsform der Erfindung, wonach dem Leistungshalbleiter zur Stromaufteilung bzw. zur Stromübernahme ein Thyristor parallel geschalten ist, wird die Anode des Thyristors am Kollektor und die Kathode des Thyristors am Emitter des Leistungshalbleiters angeschlossen, wobei das Gate des Thyristors mit dem Gate des Leistungshalbleiters in Verbindung steht.

Der Löschkondensator wird zweckmäßigerweise zwischen der Kathode des Thyristors und dem Emitter des Leistungshalbleiters geschalten.

Die Erfindung soll nachstehend anhand eines Ausführungsbeispiels sowie unter Zuhilfenahme von Figuren näher erläutert werden.

Hierbei zeigen:
- Fig. 1: eine Prinzipschaltung zum Schutz einer Einheit gegen Überspannungen mit einem IGBT als Leistungshalbleiter;
- Fig. 2: eine Ausführungsform der Schutzschaltung, die über eine mit dem Eingang in Verbindung stehende Diodenbrücke gespeist wird, und
- Fig. 3: eine weitere Ausführungsform der Schutzschaltung mit einem dem Leistungshalbleiter parallel geschalteten Thyristor.

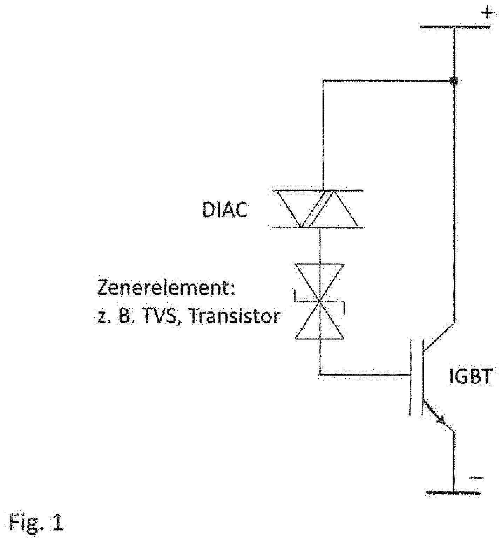

Wie aus der Fig. 1 ersichtlich, besteht die erfindungsgemäße Schaltungsanordnung zum Schutz einer aus einem Versorgungsnetz zu betreibenden Einheit gegen Überspannungen aus einem Leistungshalbleiter, beispielsweise oder bevorzugt einem IGBT.

Der Leistungshalbleiter weist zwischen seinem Kollektor und seinem Gate eine Reihenschaltung aus einem Diac (Zweirichtungsdiode) und einem Zenerelement ZE auf, wobei die Summe der Zener- und der Diac-Spannung eine Clampingspannung für den Leistungshalbleiter IGBT ergibt, welche oberhalb der Spannung des Versorgungsnetzes liegt und den Schutzpegel definiert.

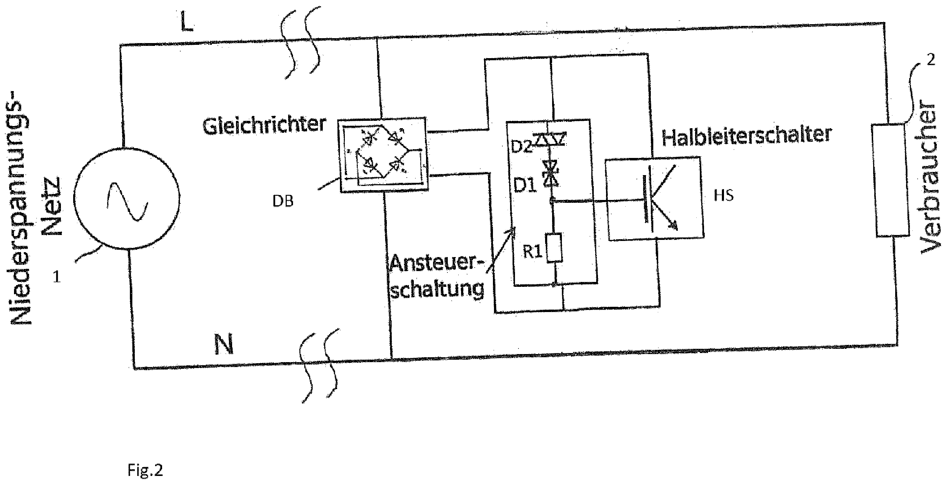

Bei der Schaltungsanordnung nach Fig. 2 ist wiederum ein Diac D2 mit einem Zenerelement D1 in Reihe geschalten, wobei diese Reihenschaltung zwischen dem Gate und dem Kollektor eines Halbleiterschalters HS liegt. Die Ansteuerschaltung umfasst bei dieser Ausführungsform noch einen Widerstand R1 zwischen Gate und Emitter des Halbleiterschalters HS. Der Widerstand R1 dient der Entstörung des Gates, aber auch zum Entladen und damit zum Abschalten des Transistors nach einem Überspannungsereignis.

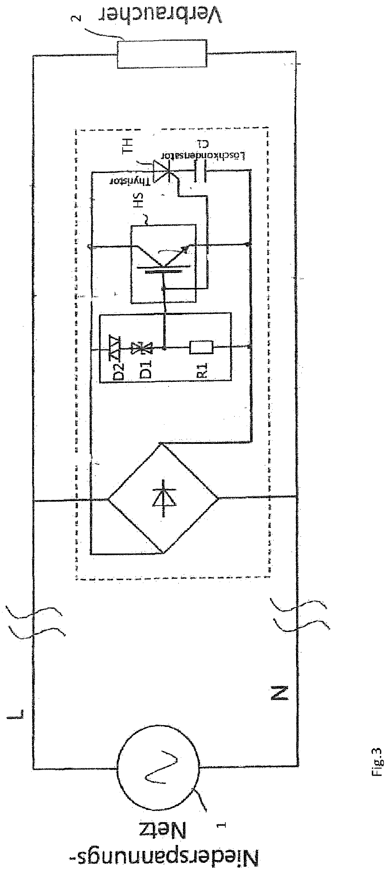

Zusätzlich ist eine Diodenbrücke DB vorhanden, so dass negative und positive Überspannungsimpulse verarbeitbar sind. Das Versorgungsnetz ist in den Fig. 2 und 3 mit dem Bezugszeichen 1 und die gegen Überspannung zu schützende Einheit mit dem Bezugszeichen 2 (Verbraucher) gekennzeichnet.

Bei der Darstellung nach Fig. 3 liegt eine Ansteuerschaltung analog derjenigen nach Fig. 2 vor, wiederum umfassend einen Diac D2 sowie ein Zenerelement D1 und einen Halbleiterschalter HS.

Dem Leistungshalbleiter HS ist ein Thyristor TH parallel geschalten.

Konkret ist die Anode des Thyristors TH am Kollektor und die Kathode des Thyristors TH am Emitter des Leistungshalbleiters HS angeschlossen, wobei das Gate des Thyristors TH mit dem Gate des Leistungshalbleiters HS in Verbindung steht.

Bei der Ausführungsform nach Fig. 3 ist zwischen der Kathode des Thyristors TH und dem Emitter des Leistungshalbleiters HS noch ein Löschkondensator C1 vorgesehen.

Bei dieser Ausführungsform dient der geclampte Halbleiterschalter, insbesondere ausgeführt als IGBT, als Triggereinheit für den Thyristor, wobei der Kondensator C1 eine Löschung des Thyristors bewirkt.

Gleichzeitig kann der Kondensator C1 als Impulsauswerteeinheit herangezogen werden.

Diesbezüglich besteht die Möglichkeit, eine Spitzenwerterfassung des Impulses oder eine Ladungsintegration zur Ermittlung des Energieinhalts des Störimpulses vorzunehmen.

## Patentansprüche

1. Schaltungsanordnung zum Schutz einer aus einem Versorgungsnetz (1) zu betreibenden Einheit (2) gegen Überspannungen mit einem Eingang mit erstem und zweitem Eingangsanschluss, die mit dem Versorgungsnetz (1) in Verbindung stehen, und einem Ausgang mit einem ersten und einem zweiten Ausgangsanschluss, an denen die zu schützende Einheit (2) anschließbar ist, sowie mit einer Schutzschaltung, die zwischen erstem und zweitem Eingangsanschluss vorgesehen ist, um die an ihr anliegende Spannung zu begrenzen und die Schutzschaltung eine Reihenschaltung aus einer Zweirichtungsdiode (D2) oder einer Thyristordiode und einem Zenerelement (D1) aufweist,
**dadurch gekennzeichnet, dass**
die Schutzschaltung einen Leistungshalbleiter (HS) aufweist, wobei zwischen Kollektor und Gate des Leistungshalbleiters die Reihenschaltung aus der Zweirichtungsdiode (D2) oder der Thyristordiode und dem Zenerelement angeschlossen ist, wobei die Spannung der Reihenschaltung eine Klemmspannung für den Leistungshalbleiter (HS) ergibt, welche oberhalb der Spannung des Versorgungsnetzes (1) liegt und den Schutzpegel definiert, der Leistungshalbleiter (HS) ein IGBT ist, welchem ein Thyristor (TH) parallel geschalten ist, wobei die Anode des Thyristors (TH) am Kollektor und die Kathode des Thyristors (TH) am Emitter des IGBT (HS) angeschlossen ist, wobei das Gate des Thyristors (TH) mit dem Gate des IGBT (HS) in Verbindung steht.

2. Schaltungsanordnung nach Anspruch 1,
**dadurch gekennzeichnet, dass**
die Schutzschaltung über eine mit dem Eingang in Verbindung stehende Diodenbrücke (DB) gespeist wird, so dass negative und positive Überspannungsimpulse ableitbar sind.

3. Schaltungsanordnung nach Anspruch 1,
**dadurch gekennzeichnet, dass**
zwischen der Kathode des Thyristors (TH) und dem Emitter des IGBT (HS) ein Löschkondensator (C1) vorgesehen ist.

## Claims

1. A circuit assembly for protecting a unit (2) to be operated from a supply network (1) against overvoltage, comprising an input having a first and a second input connection, which are connected to the supply network (1), and an output having a first and a second output connection, to which the unit (2) to be protected can be connected, and a protection circuit which is provided between the first and the second input connections in order to limit the voltage applied to it, and the protection circuit has a series connection of a bidirectional diode (D2) or a thyristor diode and a Zener element (D1),
**characterized in that**
the protection circuit has a power semiconductor (HS), wherein the series connection of the bidirectional diode or the thyristor diode and the Zener element is connected between the collector and the gate of the power semiconductor, wherein the voltage of the series connection results in a clamping voltage for the power semiconductor (HS), which lies above the voltage of the supply network (1) and defines the protection level, the power semiconductor (HS) is an IGBT, to which a thyristor (TH) is connected in parallel, wherein the anode of the thyristor (TH) is connected to the collector and the cathode of the thyristor (TH) is connected to the emitter of the IGBT (HS), wherein the gate of the thyristor (TH) is in connection with the gate of the IGBT (HS).

2. The circuit assembly according to claim 1,
**characterized in that**
the protection circuit is fed via a diode bridge (DB) in connection with the input so that negative but also positive overvoltage impulses can be dissipated.

3. The circuit assembly according to claim 1,
**characterized in that**
a quenching capacitor (C1) is provided between the cathode of the thyristor (TH) and the emitter of the IGBT (HS).

## Revendications

1. Ensemble de circuit pour protéger contre des surtensions une unité (2) à faire fonctionner à partir d'un réseau d'alimentation (1), comportant une entrée pourvue d'une première et d'une seconde borne d'entrée qui sont en connexion avec le réseau d'alimentation (1), et une sortie pourvue d'une première et d'une seconde borne de sortie auxquelles peut être connectée ladite unité (2) à protéger, ainsi qu'un circuit de protection qui est prévu entre la première et la seconde borne d'entrée pour limiter la tension appliquée à celui-ci, le circuit de protection comprenant un circuit en série constitué d'une diode bidirectionnelle (D2) ou d'une diode de thyristor et d'un élément Zener (D1),
**caractérisé en ce que**
le circuit de protection comprend un semi-conducteur de puissance (HS), le circuit en série constitué de la diode bidirectionnelle (D2) ou de la diode de thyristor et de l'élément Zener (D1) étant connecté entre le collecteur et la grille du semi-conducteur de puissance, la tension du circuit en série donnant une tension de blocage pour le semi-conducteur de puissance (HS), qui est supérieure à la tension du réseau d'alimentation (1) et qui définit le niveau de protection,
le semi-conducteur de puissance (HS) est un IGBT en parallèle duquel est connecté un thyristor (TH), l'anode du thyristor (TH) étant connectée au collecteur et la cathode du thyristor (TH) étant connectée à l'émetteur du IGBT (HS), la grille du thyristor (TH) étant en connexion avec la grille du IGBT (HS).

2. Ensemble de circuit selon la revendication 1,
**caractérisé en ce que**
le circuit de protection est alimenté via un pont de diodes (DB) en connexion avec l'entrée, permettant de dissiper des impulsions de surtension négatives et positives.

3. Ensemble de circuit selon la revendication 1,
**caractérisé en ce que**
un condensateur d'extinction (C1) est prévu entre la cathode du thyristor (TH) et l'émetteur du IGBT (HS).
